(19) Europäisches Patentamt
European Patent Office
Office européen des brevets

(11) **EP 1 285 479 B1**

(12) **FASCICULE DE BREVET EUROPEEN**

(45) Date de publication et mention de la délivrance du brevet:
**02.05.2012 Bulletin 2012/18**

(21) Numéro de dépôt: **01940614.9**

(22) Date de dépôt: **28.05.2001**

(51) Int Cl.:
*H01S 5/10* *(2006.01)*   *H01S 5/34* *(2006.01)*

(86) Numéro de dépôt international:
**PCT/FR2001/001637**

(87) Numéro de publication internationale:
**WO 2001/093384 (06.12.2001 Gazette 2001/49)**

(54) **SOURCE A UN PHOTON A BASE D'EMETTEURS DONT LES FREQUENCES SONT REPARTIES DE MANIERE CHOISIE**

EINZELPHOTONENQUELLE BASIEREND AUF STRAHLUNGSQUELLEN MIT FREI WÄHLBARER FREQUENZVERTEILUNG

SINGLE PHOTON SOURCE BASED ON TRANSMITTERS WITH SELECTIVELY DISTRIBUTED FREQUENCIES

(84) Etats contractants désignés:
**AT BE CH CY DE DK ES FI FR GB GR IE IT LI LU MC NL PT SE TR**

(30) Priorité: **29.05.2000 FR 0006824**

(43) Date de publication de la demande:
**26.02.2003 Bulletin 2003/09**

(73) Titulaires:
- **FRANCE TELECOM**
  **75015 Paris (FR)**
- **CENTRE NATIONAL DE LA RECHERCHE SCIENTIFIQUE (CNRS)**
  **75794 Paris Cedex 16 (FR)**

(72) Inventeurs:
- **GERARD, Jean-Michel**
  **F-38410 Saint Martin d'Uriage (FR)**
- **GAYRAL, Bruno**
  **F-75013 Paris (FR)**
- **LE SI, Dang**
  **F-38330 Montbonnot-St-Martin (FR)**

(74) Mandataire: **Texier, Christian et al**
**Cabinet Regimbeau**
**20, rue de Chazelles**
**75847 Paris Cedex 17 (FR)**

(56) Documents cités:
- **GERARD J -M ET AL: "Strong Purcell effect for InAs quantum boxes in three-dimensional solid-state microcavities" JOURNAL OF LIGHTWAVE TECHNOLOGY, NOV. 1999, IEEE, USA, vol. 17, no. 11, pages 2089-2095, XP002159748 ISSN: 0733-8724 cité dans la demande**
- **GAYRAL B ET AL: "Optical study of GaAs/AlAs pillar microcavities with elliptical cross section" APPLIED PHYSICS LETTERS, 23 MARCH 1998, AIP, USA, vol. 72, no. 12, pages 1421-1423, XP002159747 ISSN: 0003-6951 cité dans la demande**
- **DEPPE D G ET AL: "QUANTUM-DOT VERTICAL-CAVITY SURFACE-EMITTING LASER BASED ON THE PURCELL EFFECT" APPLIED PHYSICS LETTERS, AMERICAN INSTITUTE OF PHYSICS. NEW YORK, US, vol. 75, no. 21, 22 novembre 1999 (1999-11-22), pages 3455-3457, XP000875708 ISSN: 0003-6951**
- **TANAKA S ET AL: "STIMULATED EMISSION FROM OPTICALLY PUMPED GAN QUANTUM DOTS" APPLIED PHYSICS LETTERS, US, AMERICAN INSTITUTE OF PHYSICS. NEW YORK, vol. 71, no. 10, 8 septembre 1997 (1997-09-08), pages 1299-1301, XP000720249 ISSN: 0003-6951**

EP 1 285 479 B1

**Description**

L'invention concerne les composants opto-électroniques capables d'émettre de façon déterministe des impulsions lumineuses contenant un photon et un seul.

Les applications principales de ce composant se trouvent en métrologie et dans le domaine des télécommunications sécurisées.

Une « source à un photon » est un composant ou un système capable de générer à la demande des impulsions lumineuses contenant un et un seul photon. Une source solide à un photon performante a potentiellement des applications importantes, par exemple en métrologie (étalon de flux lumineux, ou d'énergie) ou dans le domaine des télécommunications, en permettant une sécurisation absolue des échanges en employant la crytographie quantique.

Notons que dans le domaine des télécommunications, les applications envisagées pour la cryptographie quantique concernent principalement la transmission sur fibre optique aux longueurs d'onde usuelles (1.3 - 1.55 $\mu$m), mais aussi par les télécommunications en espace libre (communication Terre - satellite ou inter-satellites, communications sous-marines dans la fenêtre de transmission bleu-verte, communications terrestres à courte distance).

Pour ce qui concerne cette application à la cryptographie quantique, il est essentiel que les impulsions délivrées par la source ne contiennent jamais plus d'un photon pour assurer une confidentialité inconditionnelle. Pour l'heure, on utilise pour des questions de disponibilité des impulsions laser très atténuées, contenant en moyenne 0,1 photon, et qui ne sont que des approximations très imparfaites d'impulsions à un photon.

Ces sources ont permis de valider la compatibilité de protocoles de communication quantique avec le réseau optique existant, mais une statistique poissonienne de leurs impulsions pose de sévères limitations pour une utilisation réelle : d'une part 90% des impulsions ne contiennent aucun photon, ce qui limite sévèrement le débit d'information transmise ; plus gravement, la sécurité est compromise par le fait que 1% des impulsions (soit 10% des impulsions utiles) contiennent plus d'un photon.

Un espion pourrait donc intercepter l'ensemble de la séquence transmise, analyser et réemettre sans erreur les impulsions contenant plusieurs photons. L'intervention de cet espion ne se traduisant que par une baisse du débit transmis et non par une augmentation du taux d'erreur, on ne pourrait la distinguer de la présence de pertes optiques sur la ligne. Il est donc important de développer une source capable de délivrer des impulsions ne contenant jamais plus d'un photon, avec une probabilité de contenir un photon aussi élevé que possible.

Si les atomes uniques en cavité permettent de réaliser une telle source, la lourdeur du système expérimental nécessaire pour préparer, stocker et manipuler ceux-ci, ne permet pas d'envisager leur application à grande échelle. Le déploiement de la cryptographie quantique repose donc sur le développement d'une source solide de photons uniques performante, à bas coût.

Une source à un photon met en oeuvre un émetteur unique (atome, ion, molécule...) afin de garantir que sous excitation électrique ou optique, le système ne stocke qu'une excitation élémentaire, et se désexcite ultérieurement en émettant au plus un photon.

L'émission de cet émetteur unique localisé est naturellement omnidirectionnelle ; il faut donc placer celui-ci dans une microcavité optique afin de collecter efficacement le rayonnement émis et de pouvoir, par exemple, l'injecter dans une fibre optique. La situation idéale est celle pour laquelle l'émission est concentrée dans un unique mode de la cavité, ce qui permet de préparer les photons uniques dans un même état quantique.

Jusqu'ici, cette combinaison d'un émetteur unique et d'une microcavité monomode n'a pas été réalisée, car elle se heurte à différents problèmes :

- les atomes, ions ou molécules sont des émetteurs très imparfaits Les molécules ont une durée de vie faible, limitée par le ternissement optique ou « photodarkening » ; atomes et ions placés dans une matrice solide présentent fréquemment un faible rendement radiatif, et leur nombre est difficile à contrôler.
- il n'existe pas à l'heure actuelle de microcavité optique monolithique réellement monomode. Yablonovitch a proposé en 1987 de partir d'un cristal artificiel à bande interdite photonique (qui ne supporte aucun mode électromagnétique dans une certaine plage de fréquences) et d'introduire de façon contrôlée dans la bande interdite un unique mode électromagnétique en introduisant un défaut idoine dans le cristal. Bien que de réels progrès aient été enregistrés en 98-99 dans le domaine de la fabrication de cristaux à bande interdite photonique tri-dimensionnelle, cette approche s'avère technologiquement très délicate à mettre en oeuvre.

Plusieurs approches ont été proposées pour résoudre l'un ou l'autre de ces problèmes.

Il est tentant de remplacer l'émetteur usuel, atome ion ou molécule par un émetteur semi-conducteur, puits quantique ou boîte quantique, dont le rendement radiatif est proche de l'unité, et qu'il est éventuellement possible de pomper électriquement.

Yamamoto et al ont ainsi proposé d'utiliser un puits quantique comme milieu actif [1], les états électroniques d'un puits n'étant pas discrets, il est alors nécessaire d'injecter une seule paire électron-trou à la fois si on veut obtenir un unique photon. Ce résultat peut être obtenu en utilisant le blocage de Coulomb pour injecter exactement un électron puis un trou dans le puits quantique. Il semble très difficile cependant dans cette approche d'élever la température de fonctionnement au-delà de 0.1 K, ce qui limite très fortement son intérêt. J.M. Gérard et B. Gayral ont également proposé d'employer une unique boîte quantique semiconductrice comme centre émetteur ([2]). Les boîtes quantiques obtenues par croissance auto-organisée présentent en effet de nombreux atouts dans le contexte, lorsqu'on les compare aux atomes, ions ou molécules plus couramment étudiés : une grande stabilité, un rendement radiatif très proche de l'unité tant que la thermoémission des porteurs est négligeable (c'est à dire T<150K pour les boîtes quantiques InAs les plus communes, émettant au voisinage de 1μm) et la possibilité d'un pompage électrique ou optique non résonant, grâce à la capture efficace de porteurs injectés dans la barrière.

Comme pour le puits quantique, rien n'empêche à priori d'injecter plusieurs paires électron-trou à la fois dans une boîte quantique, et d'observer l'émission de plusieurs photons.

On observe expérimentalement que ces photons sont émis à des longueurs d'onde différentes, correspondant à des états de charge différents de la boîte quantique, à cause de la forte interaction coulombienne entre porteurs piégés. Il suffit donc de filtrer spectralement l'émission de la boîte quantique pour observer, après un pompage impulsionnel, l'émission d'un unique photon dans une fenêtre spectrale bien choisie.

J.M. Gérard et B. Gayral ont également proposé d'utiliser « l'effet Purcell » (exaltation du taux d'émission spontanée d'un émetteur en cavité) pour collecter de façon très préférentielle les photons intéressants dans un mode donné.

Rappelons que les microcavités monolithiques usuelles (micropilier, microdisque, microsphère...) supportent un jeu discret de modes optiques confinés et un continuum de modes de fuites.

Lorsqu'on place en résonance avec un mode confiné de la microcavité un émetteur monochromatique, on observe dans certaines conditions une très forte exaltation de l'émission spontanée de l'émetteur vers ce mode. Dans le cas de boîtes quantiques en InAs, les inventeurs ont pu observer une émission 17 fois plus rapide vers cet unique mode confiné que vers l'ensemble des modes de fuites de la microcavité ([3]). Cet effet permet de coupler de l'ordre de 95% (=17/(17+1)) des photons vers le mode résonant de la microcavité.

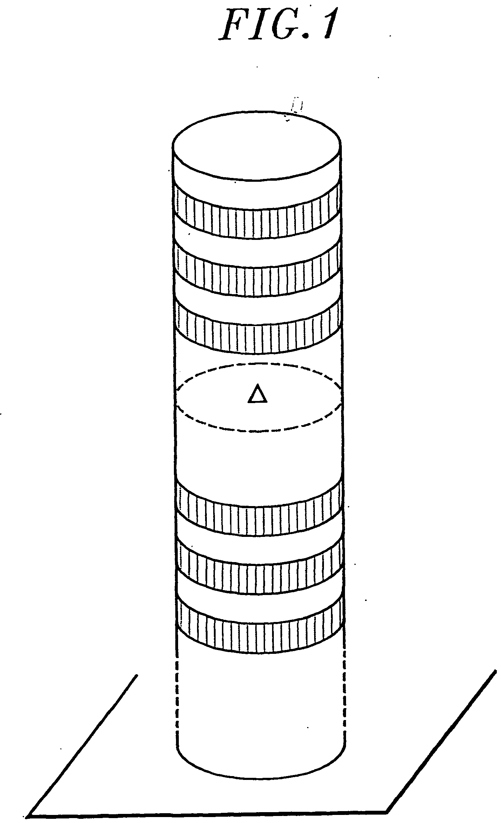

Les inventeurs ont ainsi proposé récemment de réaliser une source à un photon en plaçant une boîte quantique unique (exemple : en InGaAs) au sein d'une microcavité optique (par exemple un micropilier GaAs/AlAs) et la résonance avec un mode confiné de celle-ci (le mode fondamental de ce cas) comme schématisé à la figure 1, qui représente un micropilier GaAs/AlAs, c'est à dire un ensemble comprenant une microcavité « λ »

(c'est à dire une microcavité ayant une longueur d'onde optique d'épaisseur) en GaAs, prise en sandwich entre deux miroirs de Bragg constitués chacun d'un empilement alterné de couches quart d'onde de GaAs et d'AlAs. Une boîte quantique en InGaAs est placée dans la cavité, en résonance avec le mode de la cavité. Ce micropilier est disposé sur un substrat en GaAs. Ce micropilier présente un diamètre d'1 μm.

Cette association boîte quantique/microcavité permet en effet d'obtenir simultanément l'émission de photons uniques et un couplage très préférentiel à un mode donné, suivant le mode de fonctionnement détaillé à présent.

On réalise un pompage optique impulsionnel de la barrière de GaAs ; les porteurs photogénérés sont capturés très rapidement par la boîte quantique (ou par les surfaces libres du pilier). On ajuste la puissance de pompe de façon à injecter en moyenne de l'ordre de 5 paires électron-trou par impulsion dans la boîte quantique, afin que la probabilité d'avoir au moins une paire électron-trou dans la boîte quantique soit très proche de l'unité.

Après recombinaison des paires excédentaires, avec émission de photons à des énergies décalées par rapport au mode de la cavité par l'interaction de Coulomb entre porteurs, il reste une paire dans la boîte quantique, qui est alors en résonance avec le mode.

Grâce à l'effet Purcell, ce dernier photon est émis de façon très préférentielle dans le mode fondamental du micropilier. Le système proposé ici agit donc idéalement comme un convertisseur d'impulsions poissonniennes de pompe en un train d'impulsions à un photon. Ce convertisseur peut être intégré verticalement de façon monolithique avec un laser à émission par la surface afin de constituer une microsource de photons uniques pompée électriquement. Une température de fonctionnement au moins égale à 77K peut être obtenue.

Il est difficile d'isoler une boîte unique en microcavité. Les techniques de croissance autoorganisées conduisent usuellement à la fabrication d'ensembles denses de boîtes quantiques (typiquement 400 boîtes par μm² pour InAs/GaAs). Ces boîtes quantiques présentent des fluctuations de taille ; chaque boîte présente une raie d'émission spectralement très fine, mais leur longueur d'onde d'émission est aléatoirement distribuée sur une large plage spectrale (30 à 100 meV dans le cas des boîtes d'InAs dans GaAs). Une microcavité typique a une section de quelques μm², et contient donc de l'ordre de 1000 boîtes quantiques ; au centre de la distribution, on trouvera dans la cavité de l'ordre de 10 boîtes quantiques pour une plage spectrale de un meV. Il est donc nécessaire de réduire fortement le nombre de boîtes quantiques dans la cavité si on veut être sûr qu'une seule boîte, soit en résonance avec le mode intéressant. Différentes solutions sont alors possibles :

- on peut employer une approche technologique pour réduire le nombre de boîtes (par exemple une structuration du plan de boîtes avant de définir la microcavité) ; toutes les approches de ce type qu'on peut imaginer sont cependant très lourdes, et tendent à dégrader la qualité de la microcavité optique.

- il a été proposé en 1999 (réf [5]) de partir d'un plan de boîtes très peu dense (à peu près 10 boîtes par $\mu m^2$). On trouve alors spectralement une boîte quantique tous les 5 meV typiquement et la probabilité d'observer deux boîtes quantiques ayant la même longueur d'onde d'émission est très faible. On peut alors ajuster la température (en pratique de l'ordre de 20K) de façon à modifier l'énergie d'émission de la boîte quantique la plus proche du mode, et amener celle-ci en résonance. Dans une variante, on peut appliquer un champ magnétique pour obtenir le même effet. Cette approche impose de travailler dans une plage de paramètres de croissance très étroite pour le plan de boîtes quantiques, afin d'obtenir une densité faible. Dans le cas du système InAs/GaAs par exemple, on doit contrôler la quantité d'InAs déposée à mieux que 0.03 nm près, ce qui est une gageure. Dans la pratique on doit faire varier la quantité d'InAs de façon graduelle à la surface des échantillons épitaxiés de façon à trouver une zone utile, où la densité surfacique de boîtes quantiques est suffisamment faible. Une caractérisation et un test des structures s'en trouvent très alourdis, et le rendement d'un procédé de fabrication basé sur cette approche serait très faible.

Il a également été proposé de placer une ou quelques boîtes quantiques en microcavité pour la réalisation de lasers à très faible courant de seuil ([4]). Cette structure connue est très voisine d'une structure également connue de lasers à émission par la surface à boîtes quantiques.

Le but de la présente invention est de proposer une structure de source solide d'un photon qui peut être réalisée beaucoup plus simplement.

Cette invention permet d'obtenir un bon rendement de fabrication pour ces sources, d'abaisser leur coût de fabrication, et de permettre ainsi leur commercialisation.

Ce but est atteint selon l'invention grâce à un composant opto-électronique apte à émettre des impulsions lumineuses contenant un seul photon comprenant une cavité optique de résonance et un groupe d'émetteurs de photons placé dans cette cavité optique, un seul des émetteurs ayant une fréquence d'émission sensiblement égale à la fréquence de résonance de la cavité, caractérisé en ce que l'ensemble des émetteurs présente une répartition spectrale présentant une concentration de fréquence d'émetteurs en une fréquence donnée, et en ce que la cavité est réalisée pour avoir une fréquence de résonance suffisamment lointaine de cette fréquence de concentration pour que le nombre d'émetteurs ayant une fréquence d'émission correspondant à la fréquence de résonance de la cavité soit proche de un.

D'autres buts, caractéristiques et avantages de l'invention apparaîtront mieux à la lecture de la description détaillée qui va suivre, faite en référence aux figures annexées sur lesquelles :

- la figure 1 représente une source à un photon comprenant un seul émetteur, selon l'art antérieur ;

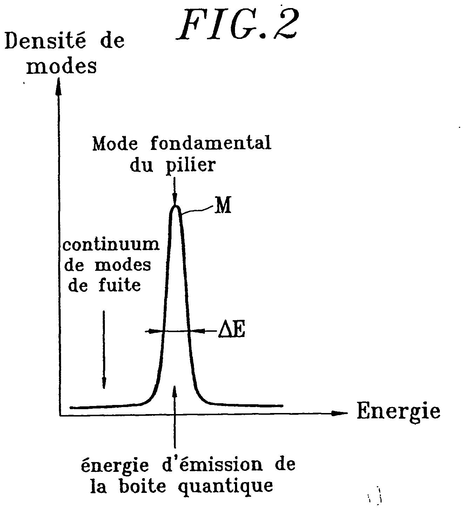

- la figure 2 est un tracé représentant une densité de modes de cavité de la source de la figure 1 ;
- la figure 3 représente une source à micropilier et à multiplicité d'émetteurs, selon l'invention ;
- la figure 4 est un tracé représentant une répartition spectrale de fréquences d'émission des émetteurs ainsi qu'un mode de résonance fondamental de cavité dans le cas de la source de la figure 3 ;
- la figure 5 est un tracé représentant partiellement la répartition spectrale des fréquences d'émission des émetteurs des figures 3 et 4 par rapport au mode de cavité de la source ;
- les figures 6 et 7 sont des tracés représentant les mêmes éléments qu'aux figures 4 et 5, mais dans le cas d'une source fonctionnant à une longueur d'onde de 1,3 $\mu m$ à 300K.
- la figure 8 représente une source selon l'invention, prévue pour fonctionner sous excitation impulsionnelle électrique ;
- la figure 9 représente une source selon l'invention, à excitation optique par un laser à émission par la surface ;
- les figures 10 et 11 représentent, chacune une source similaire à celle de la figure 3, et pompée optiquement pour la figure 10, et électriquement pour la figure 11 et couplée dans les deux cas à une fibre optique de collection des photons émis ;
- la figure 12 représente une source selon l'invention, réalisée à partir d'un microdisque à base de GaAs et de GaAlAs ;
- la figure 13 est un tracé représentant une répartition de densité de modes de boîtes quantiques par rapport à un mode de cavité dans le cas du microdisque de la figure 12 ;
- la figure 14 représente une source selon l'invention, du type à miroirs de Bragg $SiO_2/Ta_2O_5$.

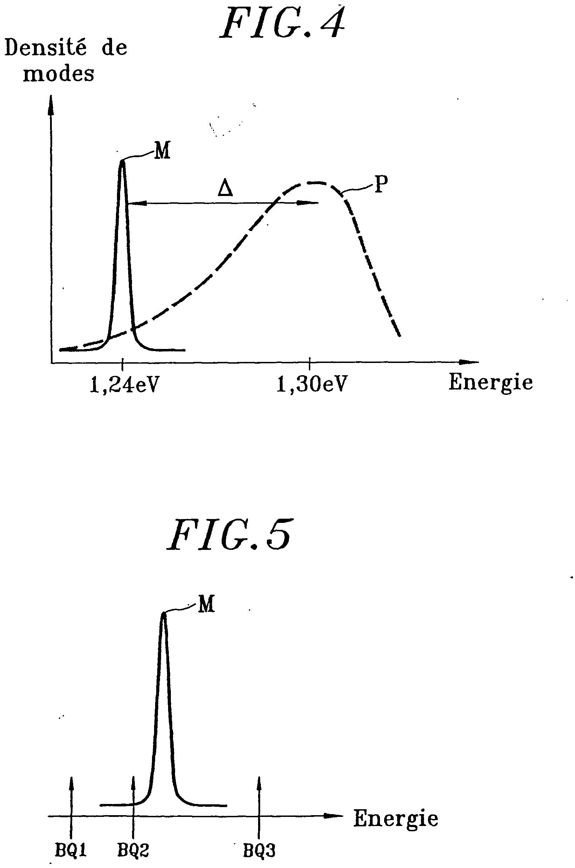

L'invention comprend, de façon caractéristique, une microcavité optique tridimensionnelle 100 dans laquelle sont insérés un ou plusieurs plans 200 de boîtes quantiques 250 de haute densité (> 100 boîtes par $\mu m^2$) et telle qu'un fort décalage spectral $\Delta$ existe entre le mode intéressant (mode fondamental) de la cavité 100 et le maximum du pic d'émission de l'ensemble des boîtes quantiques 250 ou point de concentration des pics d'émission des boîtes quantiques 250. Ce pic ou point de concentration est référencé P sur la figure 4. Le mode fondamental de la cavité est lui référencé M. Ce décalage spectral $\Delta$ est ajusté de façon à ce que la densité spectrale des boîtes quantiques 250 à l'énergie du mode M soit inférieure à $0.5/\Delta E$, où $\Delta E$ est la largeur spectrale du mode M de la cavité 100.

Ce décalage est aisément obtenu par croissance épitaxiale auto-organisée des plans de boîtes quantiques 250 à haute densité de boîtes, de façon très reproductible.

La densité et la longueur d'onde d'émission moyenne de ces plans ne dépend pas de façon critique de la quantité d'InAs déposée, et est très homogène sur l'ensemble de la surface de l'échantillon.

L'introduction d'un fort décalage spectral Δ entre le pic d'émission moyen P des boîtes 200 et le mode intéressant de la cavité 100 sur les différents dispositifs réalisés permet de réduire le nombre de boîtes 250 couplées au mode M à 0.5 Boites quantiques en moyenne (ou moins) sur les différents dispositifs réalisés. En ajustant la température, on peut alors mettre en résonance une unique boîte quantique avec le mode.

De la même façon, on peut mettre en place une telle résonance en appliquant un champ magnétique de valeur choisie sur la structure.

Ce pic moyen ou raie d'émission globale du plan de boîtes 250, peut être placée du côté « hautes énergies » ou du côté « basses énergies » du mode de cavité M. Il est cependant préférable de la placer du côté « hautes énergies » du mode M afin d'éviter de collecter de l'émission provenant de transitions entre états excités des boîtes quantiques 250.

Pour certaines familles de matériaux, telles que InAs/GaAs, la distribution spectrale des boîtes quantiques 250 est décrite par une gaussienne en très bonne approximation ; il est alors facile de calculer l'écart Δ pic moyen P/ mode M.

Si cette distribution est moins bien connue ou moins régulière, Δ peut toujours être ajusté de façon expérimentale.

On décrira maintenant quelques exemples de réalisation de manière détaillée.

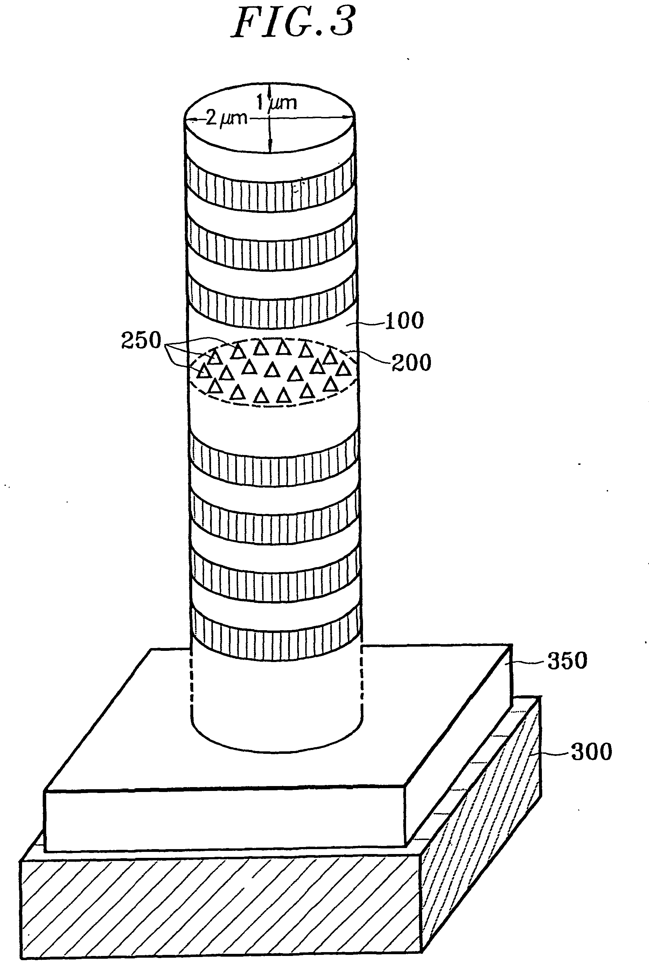

Dans l'exemple représenté à la figure 3, la microcavité 100 est en forme de pilier cylindrique à section elliptique.

Sur cette figure 3, on a représenté une structure conforme à l'invention, fonctionnant à une longueur d'onde de 1$\mu$m, utilisant un micropilier GaAs/AlAs et des boîtes quantiques InGaAs.

Plus précisément, la cavité est prise en sandwich entre deux miroirs de Bragg qui sont constitués chacun par une série alternée de couches quart d'onde GaAs et AlAs.

La section présente une excentricité suffisante pour que le mode fondamental de cette cavité soit non dégénéré [6] (exemple : petit axe 1 $\mu$m, grand axe 2$\mu$m).

On insère lors de la croissance au coeur de la structure un plan de boîtes quantiques d'InAs ou InGaAs 200 de densité 400 boîtes par $\mu$m$^2$ émettant au voisinage de $E_0$ = 1.29 eV à 77K, et présentant une largeur spectrale typique $\sigma$ = 80meV. Le nombre de boîtes dans le pilier est donc voisin de N = 310, et leur distribution en fonction de l'énergie s'écrit :

$$n(E)dE = \frac{2N}{\sigma\sqrt{\pi}}\, e^{\frac{-4(E-E_0)^2}{\sigma^2}}\, dE$$

Pour une largeur de mode ΔE de 1 meV (représentative de l'état de l'art, voir réf ([6]), on trouve que le décalage Δ doit être au moins de 60 meV pour que moins de 0,5 boîtes en moyenne soient couplées au mode M.

.On calculera donc par exemple la structure de la microcavité 200 de façon à ajuster l'énergie de son mode fondamental à 1,23 eV. Cette microcavité 200 est, comme décrit précédemment, ici réalisée de manière connue sous la forme d'un micropilier à miroirs réalisés en GaAs/AlAs.

La structure est placée sur une embase 300 (refroidisseur Stirling) chargée de maintenir sa température à un point de consigne voisin de 77K, pour lequel une boîte quantique unique est couplée au mode fondamental M. Entre l'embase 300 et le micropilier est placé un substrat 300 en GaAs. La structure est pompée optiquement par un laser impulsionnel.

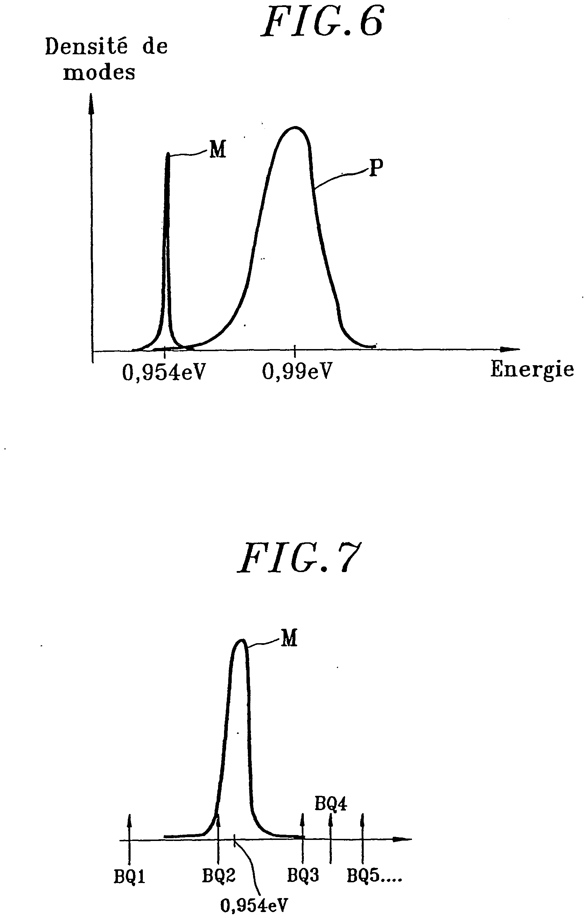

Aux figures 6 et 7, on présente les résultats obtenus avec une structure similaire à celle de la figure 3 mais adaptée à une émission à la longueur d'onde de 1,3 $\mu$m et à la température ambiante. Le mode fondamental est à 0.954 eV (1.3 $\mu$m) à 300 K ; le plan de boîtes quantiques contient 400 boîtes/$\mu$m$^2$, émet au voisinage de 0.99 eV à 300K, et présente une largeur spectrale de 40meV. On vérifie facilement que le nombre de boîtes 250 couplées au mode M est inférieur à 0.5 en moyenne.

La figure 7 représente plus particulièrement une distribution aléatoire de boîtes autour du mode M.

On retrouve sur ces figures 6 et 7 une densité de modes et une distribution spectrale moyenne de boîtes quantiques (figure 6), telles qu'un écart important existe entre M et P, et un exemple d'une réalisation particulière de la distribution aléatoire de boîtes (figure 7).

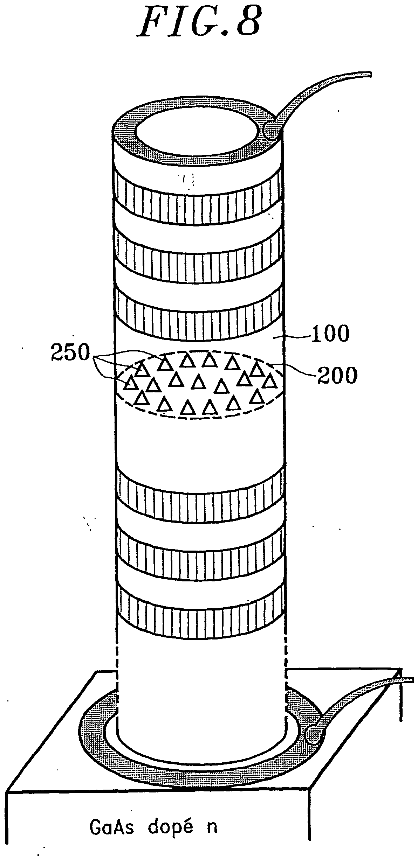

La structure de la figure 8 correspond à une structure similaire à celle de la figure 3, à ceci près que les miroirs du micropilier sont dopés et contactés électriquement aux extrémités du pilier par un générateur d'impulsions électriques, de façon à pouvoir assurer une excitation électrique du système.

Dans ce cas, le miroir de Bragg supérieur est constitué de couches alternatives GaAs/AlAs dopés p et le miroir inférieur est constitué de couches alternatives GaAs/AlAs dopés n. La couche 100 formant la cavité est en GaAs non intentionnellement dopée. Le micropilier est disposé sur un substrat en GaAs dopé n.

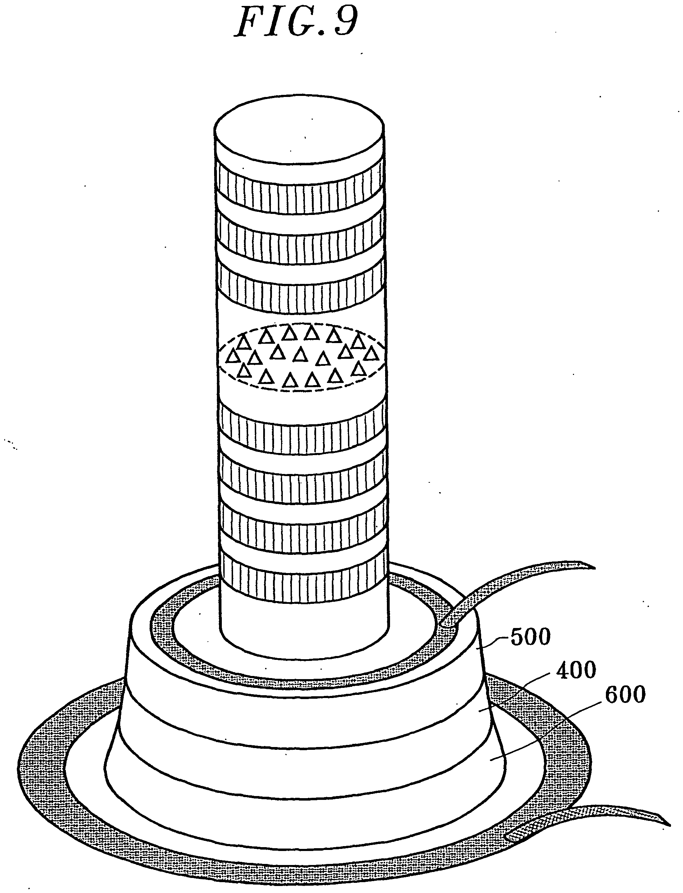

A la figure 9, on a représenté une structure identique à celle de la figure 3, à ceci près qu'elle est intégrée de façon monolithique à un microlaser semiconducteur à émission par la surface.

Le micropilier forme une source à un photon à la longueur d'onde λ, et le microlaser forme une source à la longueur d'onde λ', λ' étant inférieur à λ. Le microlaser est constitué de trois couches, c'est à dire d'une couche active 400 prise en sandwich entre deux miroirs de Bragg 500 et 600 respectivement dopés p (côté micropilier) et dopé n (à l'opposé du micropilier). Le microlaser est contacté par des électrodes à ses deux extrémités, une des deux électrodes entourant la base du micropilier.

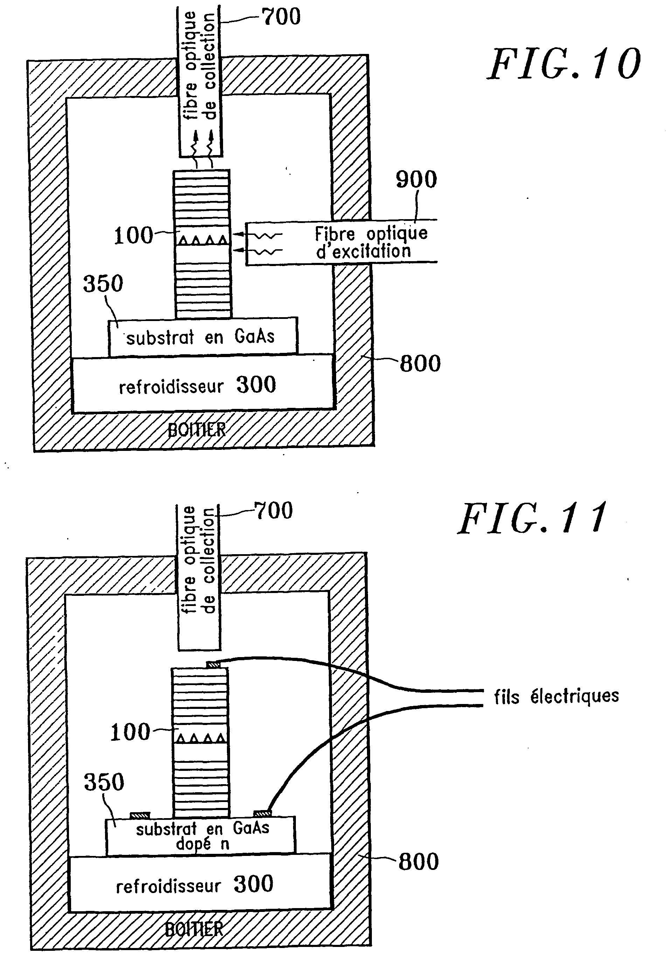

Aux figures 10 et 11, on a représenté une structure identique à celle de la figure 3, couplée à une fibre optique 700 assurant la collection des photons émis, et pompée électriquement (figure 11) ou optiquement par une fibre optique (figure 10).

Dans ces deux exemples, la structure de la figure 3 avec son refroidisseur 300 et son substrat 350 est placée dans un boîtier 800 et la fibre optique de collection 700 traverse le boîtier 800 depuis une extrémité supérieure du micropilier.

Dans le cas de la figure 11, les électrodes d'excitation sont placées comme dans le cas de la figure 8.

Dans le cas de la figure 11, une fibre optique d'excitation 900 traverse le boîtier latéralement pour venir exciter la cavité 100 du micropilier.

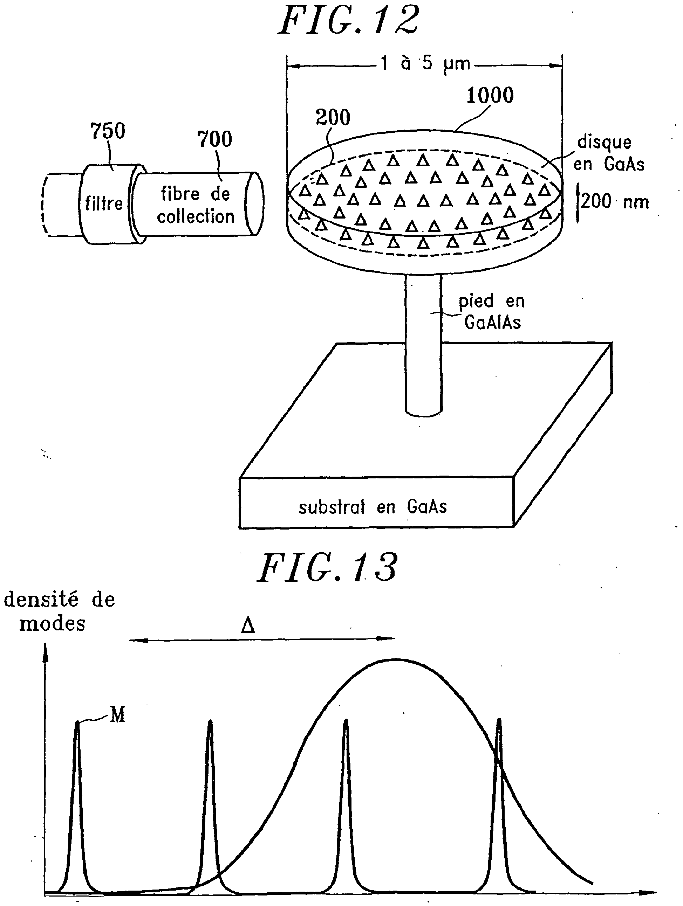

A la figure 12, on a représenté un microdisque 1000 à base de GaAs et de GaAlAs, contenant un plan de boîtes quantiques 200 en InGaAs.

Ce microdisque 1000 est disposé sur un pied allongé en GaAlAs, lui-même disposé sur un substrat en GaAs.

L'épaisseur du disque est de l'ordre de 200 nm, et le diamètre du disque (1 à 5 $\mu$m) est ajusté de façon à ce que l'un de ses modes confinés, le mode M de la figure 13, soit suffisamment décalé par rapport à l'émission moyenne de l'ensemble des boîtes quantiques, c'est à dire le point de concentration des fréquences des boîtes quantiques 250, et soit couplé en moyenne à un faible nombre de boîtes (0.1 à 0.5).

Une fibre optique 700 (ou un guide d'onde en semiconducteur) assure la collection des photons émis. Un filtre passe-bande 750 est employé pour sélectionner les photons émis dans le mode M par rapport à l'émission parasite émise dans les autres modes. Dans un mode particulier de réalisation, ce filtre 750 peut être intégré à la fibre comme sur la figure 12.

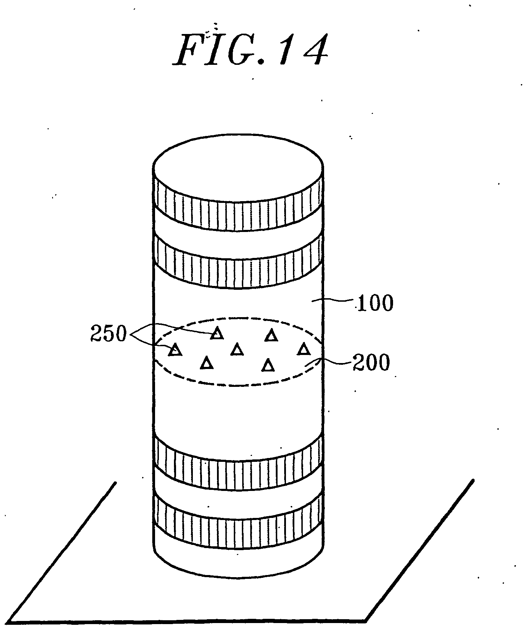

A la figure 14, on a représenté un micropilier cylindrique à section elliptique constitué par une couche cavité 100 en GaN ou GaAlN contenant un plan de boîtes quantiques 200 en InGaN, et, de part et d'autre de la couche 100, des miroirs de Bragg diélectriques (ex. à base de Si02 et de Ta205). Le miroir de Bragg inférieur peut également être réalisé à base d'un empilement de couches GaN et GaAlN. Dans une variante, les boîtes quantiques sont en GaN et la couche cavité en GaAlN.

On peut choisir une longueur d'onde d'émission pour cette source à un photon qui soit dans le domaine visible (en particulier le bleu et le vert) ou proche ultra-violet, en jouant sur la composition et la taille des boîtes quantiques en InGaN ou en GaN.

Dans le cas de cette figure, de façon plus accessoire, on pourra :

1) ajouter un système permettant de stabiliser et d'ajuster la température ;
2) ajouter un système permettant de collecter les photons uniques (fibre, guide...) ;
3) ajouter un système assurant un filtrage spectral de l'émission parasite des boîtes quantiques non couplées au mode ;
4) intégrer les moyens permettant un pompage optique ou électrique

impulsionnel des boîtes quantiques en microcavité.

On prévoit des modes de réalisation préférentiels, correspondant par exemple à l'une des différentes variantes des figures annexées, dans lesquelles on adopte préférentiellement, et ce pour une facilité et une fiabilité de réalisation toute particulière :

- des boîtes quantiques en un matériau de formule $In_xGa_{1-x}As$, avec x compris entre 0,5 et 1 ;
- la couche cavité en $Ga_yAl_{1-y}As$ avec y compris entre 0,5 et 1, notamment dans le cas de boîtes quantiques selon le tiret précédent ;
- les boîtes quantiques en InAs et la couche cavité en GaAs (choix particulièrement avantageux)
- dans une variante, les boîtes quantiques en $In_xGa_{1-x}N$ avec x compris entre 0 et 1.

[1] A. Imamoglu et Y. Yamamoto, Phys. Rev. Lett. 72, 210, 1994 ; J.Kim et al, Nature, 397, 500, 1999
[2] J.M. Gerard, B. Gayral in « QUED phenomena and applications of microcavities and photonic crystals » H. Benisty, J.M. Gérard, J. Rarity et C. Weisbuch éditeurs, Springer-Verlag, Berlin 1999 ; J.M. Gérard et B. Gayral, J.

Lightwawe Technol. 17, 2089 (1999).

[3] B. Gayral, J.M. Gérard, A. Lemaître, C.Dupuis, L.Manin et J.L. Pelouard, Appl. Phys. Lett. 75, 1908 (1999) ; J.M. Gerard, B. Sermage, B. Gayral, B. Legrand, E.Costard, V. Thierry-Mieg Phys.Rev. Lett 81, 1110 (1998).

[4] M. Yamanishi et Y.Yamamoto, J.J.A.P. 30, L60, 1991 ; et Oliver Benson et al. Phys.Rev.Let.84, 2513, 2000.

[5] J.M. Gerard, B. Gayral in « CQED phenomena and applications of microcavities and photonic crystals » H. Benisty, J.M. Gérard, J. Rarity et C.Weisbuch éditeurs, Springer-Verlag 1999 ; J.M. Gérard et B. Gayral, J. Lightwawe Technol. 17, 2089 (1999).

[6] B. Gayral et al. Appl. Phys. Lett.72, 1421, 1998

## Revendications

1. Composant opto-électronique apte à émettre des impulsions lumineuses contenant un seul photon comprenant une cavité optique de résonance (100) et un groupe d'émetteurs de photons (250) placé dans cette cavité optique (100), un seul des émetteurs (250) ayant une fréquence d'émission sensiblement égale à la fréquence de résonance (M) de la cavité (100), **caractérisé en ce que** l'ensemble des émetteurs (250) présente une répartition spectrale présentant une concentration de fréquences d'émetteurs (250) en une fréquence donnée (P), correspondant au pic moyen d'émission du groupe d'émetteurs, et **en ce que** la cavité (100) est telle qu'entre la fréquence de résonance (M) de la cavité (100) et la fréquence donné (P) il y a un décalage spectral $\Delta$, ledit décalage spectral $\Delta$ étant tel que la densité spectrale du groupe d'émetteurs de photons (250), définie par la fonction de distribution du nombre d'émetteurs par unité d'énergie, à l'énergie de la fréquence de résonance (M), est inférieure à $0,5/\Delta E$, où $\Delta E$ est la largeur spectrale de la fréquence de mode (M) de la cavité (100).

2. Composant selon la revendication 1, **caractérisé en ce que** les émetteurs (250) sont élaborés à partir de un ou plusieurs matériaux semiconducteurs.

3. Composant selon la revendication 2, **caractérisé en ce que** les émetteurs (250) sont des boîtes quantiques semi-conductrices.

4. Composant selon l'une quelconque des revendications précédentes, **caractérisé en ce qu'**il inclut des moyens pour régler les fréquences d'émission des émetteurs de sorte que la fréquence d'un seul émetteur corresponde à la fréquence de résonance de la cavité,

5. Composant selon l'une quelconque des revendications précédentes, **caractérisé en ce qu'**il inclut un moyen (750) pour filtrer le ou les photons émis à la fréquence du mode de cavité (M) par rapport aux photons des émetteurs non couplés au mode de cavité.

6. Composant selon l'une quelconque des revendications précédentes, **caractérisé en ce qu'**il inclut des moyens de pompage (400, 500, 600, 900) optiques ou électriques impulsionnels des émetteurs (250).

7. Composant selon l'une quelconque des revendications précédentes, **caractérisé en ce qu'**il inclut des moyens (700) pour collecter les impulsions à un photon émises.

8. Composant selon l'une quelconque des revendications précédentes, en combinaison avec la revendication 3, **caractérisé en ce que** les boîtes quantiques sont en $In_xGa_{1-x}As$, avec x compris entre 0,5 et 1.

9. Composant selon la revendication 8, **caractérisé en ce que** la cavité est constituée par une couche en $Ga_yAl_{1-y}As$, avec y compris entre 0,5 et 1.

10. Composant selon les revendications 8 et 9 en combination, **caractérisé en ce que** x=1 et y=1.

11. Composant selon l'une quelconque des revendications 1 à 7, en combinaison avec la revendication 3, **caractérisé en ce que** les boîtes quantiques sont en $In_xGa_{1-x}N$ avec x compris entre 0 et 1.

## Claims

1. Opto-electronic component capable of emitting light pulses containing a single photon comprising a resonant optical cavity (100) and a group of photon emitters (250) placed in this optical cavity (100), a single one of these emitters (250) having an emission frequency substantially equal to approximately the resonant frequency (M) of the cavity (100), **characterised in that** all the emitters (250) have a spectral distribution with a concentration of frequencies of emitters (250) at a given frequency (P) corresponding to the mean emission peak of the group of emitters, and **in that** the cavity (100) is such that, between the resonant frequency (M) of the cavity (100) and the given frequency (P), there is a spectral shift $\Delta$, said spectral shift $\Delta$ being such that the spectral density of the group of photon emitters (250), defined by the distribution function of the number of emitters per unit of energy, at the energy of the resonant frequency (M), is less than -0.5/$\Delta$E, where $\Delta$E is the spectral width of the modal frequency (M) of the cavity (100).

2. Component according to claim 1, **characterised in that** the emitters (250) are generated from one or several semi-conducting materials.

3. Component according to claim 2, **characterised in that** the emitters (250) are semi-conducting quantum boxes.

4. Component according to any one of the previous claims, **characterised in that** it includes means for adjusting the emission frequencies of emitters such that the frequency of a single emitter corresponds to the resonant frequency of the cavity.

5. Component according to any one of the previous claims, **characterised in that** it includes a means (750) for filtering the photon(s) emitted at the frequency of the cavity mode (M) from photons of emitters not coupled to the cavity mode.

6. Component according to any one of the previous claims, **characterised in that** it includes optical or electrical pulse pumping means (400, 500, 600, 900) of the emitters (250).

7. Component according to any one of the previous claims, **characterised in that** it includes means (700) for collecting the emitted single photon pulses.

8. Component according to any one of the previous claims, in combination with claim 3, **characterised in that** the quantum boxes are made of $In_xGa_{1-x}As$, where x is between 0.5 and 1.

9. Component according to claim 8, **characterised in that** the cavity is composed of a $Ga_yAl_{1-y}As$ layer, where y is between 0.5 and 1.

10. Component according to claims 8 and 9 in combination, **characterised in that** x = 1 and y = 1.

11. Component according to any one of claims 1 to 7 in combination with claim 3, **characterised in that** the quantum boxes are made of $In_xGa_{1-x}N$, where x is between 0 and 1.

**Patentansprüche**

1. Optoelektronisches Bauteil, welches für die Emission von ein einzelnes Photon enthaltenden Lichtimpulsen eingerichtet ist und einen optischen Resonanzhohlraum (100) und eine Gruppe von Photonensendern (250), die in dem optischen Hohlraum (100) angeordnet sind, aufweist, wobei ein einzelner der Sender (250) eine Emissionsfrequenz hat, die im Wesentlichen gleich der Resonanzfrequenz (M) des Hohlraums (100) ist, **dadurch gekennzeichnet, dass** die Einheit von Sendern (250) eine spektrale Verteilung aufweist, die eine Konzentration von Frequenzen der Sender (250) bei einer gegebenen Frequenz (P) hat, die der mittleren Emissionsspitze der Gruppe von Sendern entspricht, und dass der Hohlraum (100) derart ist, dass zwischen der Resonanzfrequenz (M) des Hohlraums (100) und der gegebenen Frequenz (P) eine spektrale Versetzung. $\Delta$ vorliegt, wobei die spektrale Versetzung $\Delta$ derart ist, dass die spektrale Dichte der Gruppe von Photonensendern (250), die durch die Verteilungsfunktion der Anzahl von Sendern pro Energieeinheit definiert ist, bis zur Energie der Resonanzfrequenz (M) unterhalb von 0,5/$\Delta$E liegt, wobei $\Delta$E die spektrale Breite der Modenfrequenz (M) des Hohlraums (100) ist.

2. Bauteil nach Anspruch 1, **dadurch gekennzeichnet, dass** die Sender (250) aus einem oder mehreren Halbleitermaterialien ausgearbeitet sind.

3. Bauteil nach Anspruch 2, **dadurch gekennzeichnet, dass** die Sender (250) halbleitende Quantengehäuse sind.

4. Bauteil nach einem der vorstehenden Ansprüche, **dadurch gekennzeichnet, dass** es Mittel zur Einstellung der Emissionsfrequenzen der Sender derart, dass die Frequenz eines einzelnen Senders der Resonanzfrequenz des Hohlraums entspricht, enthält.

5. Bauteil nach einem der vorstehenden Ansprüche, **dadurch gekennzeichnet, dass** es Mittel (750) zur Filterung des oder der Photonen, die bei der Modenfrequenz (M) des Hohlraums emittiert werden, in Bezug auf die Photonen der Sender, die nicht an den Modus des Hohlraums gekoppelt sind, enthält.

6. Bauteil nach einem der vorstehenden Ansprüche, **dadurch gekennzeichnet, dass** es optische oder elektrische impulsmäßige Pumpmittel (400, 500, 600, 900) der Sender (250) enthält.

7. Bauteil nach einem der vorstehenden Ansprüche, **dadurch gekennzeichnet, dass** es Mittel (700) zum Erfassen der zu einem Photon emittierten Impulse enthält.

8. Bauteil nach einem der vorstehenden Ansprüche, in Verbindung mit Anspruch 3, **dadurch gekennzeichnet, dass** die Quantengehäuse aus $In_xGa_{1-x}As$ mit x zwischen 0,5 und 1 sind.

9. Bauteil nach Anspruch 8, **dadurch gekennzeichnet, dass** der Hohlraum durch eine Schicht aus $Ga_yAl_{1-y}As$ mit y zwischen 0,5 und 1 gebildet ist.

10. Bauteil nach Anspruch 8 und 9 in Kombination, **dadurch gekennzeichnet, dass** x=1 und y=1.

11. Bauteil nach einem der Ansprüche 1 bis 7 in Kombination mit Anspruch 3, **dadurch gekennzeichnet, dass** die Quantengehäuse aus $In_xGa_{1-x}N$ mit x zwischen 0 und 1 sind.

# FIG.1

△

FIG.2

Densité de modes

Mode fondamental du pilier

M

continuum de modes de fuite

ΔE

Energie

énergie d'émission de la boite quantique

EP 1 285 479 B1

# FIG.3

12

## FIG.4

Densité de
modes

M

Δ

P

1,24eV        1,30eV        Energie

## FIG.5

M

Energie

BQ1    BQ2        BQ3

# FIG.6

Densité de
modes

0,954eV     0,99eV        Energie

# FIG.7

BQ1     BQ2     BQ3    BQ5....

0,954eV

# FIG.8

GaAs dopé n

# FIG.9

500
400
600

*FIG.10*

fibre optique
de collection — 700

900

Fibre optique
d'excitation

100

350

substrat en GaAs

refroidisseur **300**

800

BOITIER

*FIG.11*

fibre optique
de collection — 700

100

fils électriques

350

substrat en GaAs
dopé n

refroidisseur **300**

800

BOITIER

## FIG.12

1 à 5 µm

200
1000
disque en GaAs
200 nm

750
filtre

700
fibre de collection

pied en GaAlAs

substrat en GaAs

## FIG.13

densité de modes

Δ

M

# FIG.14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **A. IMAMOGLU ; Y. YAMAMOTO.** *Phys. Rev. Lett.,* 1994, vol. 72, 210
- **J.KIM et al.** *Nature,* 1999, vol. 397, 500
- **J.M. GERARD ; B. GAYRAL.** QUED phenomena and applications of microcavities and photonic crystals. Springer-Verlag, 1999
- **J.M. GÉRARD ; B. GAYRAL.** *J. Lightwawe Technol.,* 1999, vol. 17, 2089
- **B. GAYRAL ; J.M. GÉRARD ; A. LEMAÎTRE ; C.DUPUIS ; L.MANIN ; J.L. PELOUARD.** *Appl. Phys. Lett.,* 1999, vol. 75, 1908
- **J.M. GERARD ; B. SERMAGE ; B. GAYRAL ; B. LEGRAND ; E.COSTARD ; V. THIERRY-MIEG.** *Phys.Rev. Lett,* 1998, vol. 81, 1110
- **M. YAMANISHI ; Y.YAMAMOTO.** *J.J.A.P.,* 1991, vol. 30, L60
- **OLIVER BENSON et al.** *Phys.Rev.Let.,* 2000, vol. 84, 2513
- **J.M. GERARD ; B. GAYRAL.** CQED phenomena and applications of microcavities and photonic crystals. Springer-Verlag, 1999
- **B. GAYRAL et al.** *Appl. Phys. Lett.,* 1998, vol. 72, 1421